# EUROPEAN PATENT SPECIFICATION

(11) **EP 0 644 648 B1**
(45) Date of publication and mention of the grant of the patent: **27.12.1996**
(21) Application number: 94114548.4
(22) Date of filing: 15.09.1994
(51) Int. Cl.: H02P 21/00, H02P 7/628

(54) **Control method and apparatus and malefunction detection method and apparatus for AC motor**
Steuergerät bzw. Steuerverfahren und Gerät und Verfahren zur Feststellung eines Fehlfunktionierens eines Wechselstrommotors
Appareil et méthode de commande et appareil et méthode de détection de dysfonctionnement pour moteur à courant alternatif

(30) Priority: 17.09.1993 JP 230648/93; 11.05.1994 JP 97089/94
(43) Date of publication of application: 22.03.1995
(60) Divisional application: 96105889.8
(73) Proprietor: FUJI ELECTRIC CO. LTD., Kawasaki 210 (JP)
(72) Inventor: Tajima, Hirokazu, Kawasaki-ku, Kawasaki 210 (JP); Umida, Hidetoshi, Kawasaki-ku, Kawasaki 210 (JP)
(74) Representative: Hoffmann, Eckart, Dipl.-Ing.

(56) References cited:
- EP-A- 0 500 121
- DE-A- 3 820 125
- PATENT ABSTRACTS OF JAPAN vol. 17, no. 319 (E-1383) 17 June 1993 & JP-A-05 030 792 (MITSUBISHI ELECTRIC CORP.) 5 February 1993
- PATENT ABSTRACTS OF JAPAN vol. 14, no. 560 (E-1012) 13 December 1990 & JP-A-02 241 389 (SUMITOMO HEAVY IND. LTD.) 26 September 1990

## Description

The present invention relates to a control method and apparatus for an AC motor that detects a primary resistance of the AC motor with excellent accuracy and to a malfunction detection method and apparatus that detects a malfunction by comparing estimated primary resistance values of each phase.

Magnetic flux and torque of an AC motor can be controlled by resolving a current flowing through the AC motor into a magnetizing current component parallel to the magnetic flux and a torque current component perpendicular to the magnetic flux, and by controlling the magnetizing current and the torque current components independently. It is well known that the speed of the AC motor can be controlled highly accurately by the so-called transvector control method that treats the current of the AC motor as a vector consisting of two components.

Since, in the transvector control of the AC motor, the AC motor is controlled by using an equivalent circuit of the AC motor as a control model, control constants based on the equivalent circuit constants are pre-set to a control apparatus. Usually, designed values of the motor constants are used as these control constants. However, there are differences between the designed and actual values of the motor constants and the differences cause control errors. Variations of the motor constants during driving the motor also cause control errors. Furthermore, the transvector control method can not be applied when the constants of the motor already in service are unknown.

In the transvector control, it is necessary to detect the induced electromotive force which relates to the magnetic flux. The induced electromotive force is calculated by subtracting the voltage drop across the internal impedance of the motor from the terminal voltage of the motor. The voltage drop across the internal impedance of the motor is obtained by multiplying the magnetizing current component and a primary resistance value of the motor. Generated torque becomes insufficient especially when the motor is driven at low speed, because an appropriate output reference voltage value can not be calculated when the primary resistance value is different from the pre-set value. To solve this problem, a method has been proposed that obtains the primary resistance value by dividing an output voltage by a phase current of predetermined value which is made to flow through the motor (See RM-85-26, Technical Meeting Paper on Rotating Machine, p. 65, Institute of Electrical Engineers of Japan).

The method of calculating the primary resistance value by dividing output voltage by the phase current according to the prior art requires high precision detectors, because the prior art method is affected by the precision of the voltage and current detectors. However, since the primary resistance value of a large capacity motor is small, even the high precision detectors would not improve accuracy of the measurements. Moreover, in the transient period, induced electromotive force of the magnetizing inductance is added to the voltage drop across the primary resistance. Since decay time of the induced electromotive force is prolonged in an AC motor of large secondary time constant, for example a large capacity AC motor, it takes long time for the resistance value obtained by dividing output voltage by a current to reach a true primary resistance value. Besides, motor windings through which a current flows or semiconductor switching elements of the power converter are different depending on a phase angle of voltage applied to the AC motor. Since resistance values of the motor windings or the semiconductor switching elements show variations, the measured primary resistance value shows variation depending on phase angle difference which further causes a control error. In controlling the general-purpose AC motors, actual torque is not always used for further control of the AC motors.

A method and an apparatus according to the pre-characterizing portions of claim 1, 4, 5 and 8, respectively, are disclosed in EP-A-0 500 121.

In view of the foregoing, an object of the present invention is to provide a control method and apparatus that measures, without using high precision detectors, the primary resistance of an AC motor with high accuracy in a short time by eliminating the errors caused by the phase angle difference.

Another object of the present invention is to provide a control method and apparatus that detects malfunctions such as breaking of wiring, open phases and three-phase unbalance of the AC motor or the power converting means.

These objects are achieved with a control method and a control apparatus, respectively, as claimed.

The control method according to an embodiment of the invention obtains an estimated primary resistance R₁^{#} as a result of an integral operation or a proportional plus integral operation on the difference between a reference magnetizing current value I_{M}* and a detected magnetizing current value I_{M}. The voltage drop across the primary resistance is estimated by multiplying the estimated primary resistance value R₁^{#} and the reference magnetizing current value I_{M}*. A reference magnetizing voltage value V_{M}* is obtained by adding an amplified deviation of the reference magnetizing current value I_{M}* from the detected magnetizing current value I_{M} and the estimated voltage drop value. The reference magnetizing voltage value V_{M}* is expressed by the following equation 1. The estimated primary resistance R₁^{#} is expressed by the following equation 2 or 3. In these equations, K_{A} is a proportional gain of an amplifying means, K_{P} a proportional gain of a proportional plus integral means, and K_{I} an integral gain of an integral means or the proportional plus integral means.${\text{V}}_{\text{M}} {\text{*= K}}_{\text{A}} {\text{(I}}_{\text{M}} {\text{*-I}}_{\text{M}} {\text{)+R}}_{\text{1}} {\text{}}^{\text{#}} {\text{·I}}_{\text{M}} \text{*}$${\text{R}}_{\text{1}} {\text{}}^{\text{#}} {\text{= K}}_{\text{I}} {\text{∫(I}}_{\text{M}} {\text{*-I}}_{\text{M}} \text{) · dt}$${\text{R}}_{\text{1}} {\text{}}^{\text{#}} {\text{= K}}_{\text{p}} {\text{(I}}_{\text{M}} {\text{*-I}}_{\text{M}} {\text{)+K}}_{\text{I}} {\text{∫(I}}_{\text{M}} {\text{*-I}}_{\text{M}} \text{) ·dt}$

In a steady state, the following equation 4 holds.${\text{I}}_{\text{M}} {\text{= V}}_{\text{M}} {\text{*/R}}_{\text{1}}$

The following equation 5 is obtained from equations 1 and 4.${\text{I}}_{\text{M}} \text{=} \frac{{\text{K}}_{\text{A}} {\text{+ R}}_{\text{1}} \text{#}}{{\text{K}}_{\text{A}} {\text{+ R}}_{\text{1}}} {\text{· I}}_{\text{M}} \text{*}$

Since, in equations 2 and 3, the estimated primary resistance value R₁^{#} increases when the deviation between the reference and detected magnetizing current values (I_{M}*-I_{M}) is positive and R₁^{#} decreases when the deviation (I_{M}*-I_{M}) is negative, the reference magnetizing voltage value V_{M}* is corrected by equation 1. Therefore, when the deviation (I_{M}*-I_{M}) decreases to zero, the estimated primary resistance value R₁^{#} coincides with the actual primary resistance value R₁ from equation 5.

A control method according to the invention obtains a total resistance value of the winding resistance of each phase, the wiring resistance between the power converting means and the AC motor, and the resistance of the switching elements of the power converting means by switching-on one switching element on the positive side and another switching element on the negative side (while avoiding pairs which cause an arm short circuit) and by measuring six sets of resistance values of two phases of the three-phase AC motor when a current is made to flow through the two phases. The most appropriate primary resistance value for the control is obtained by calculating a mean value of the total resistance values of all the phases.

As described earlier, since the decay time of the induced electromotive force is prolonged in an AC motor of large secondary time constant, for example a large capacity AC motor, it takes long time for the resistance value obtained by dividing output voltage by a current to reach a true primary resistance value. To solve this problem, the control method according to another embodiment of the invention determines in advance a reference magnetizing current pattern in which the reference magnetizing current value I_{M}* decreases from an initial large value at the start of the AC motor to a predetermined value after a predetermined period of time has elapsed. As a result of this, the necessary time for estimating the primary resistance value is shortened, because an actual magnetizing current takes a large value immediately after the start of the AC motor, by which influence of the induced electromagnetic force on the voltage drop across the primary resistance is reduced.

Yet another embodiment of the invention obtains a total resistance value of winding resistance of each phase, wiring resistance between the power converting means and the AC motor, and resistance of the switching elements of the power converting means, compares the resistance values of all the phases, and then detects malfunctions such as breaking of wire, open phases and three-phase unbalance of the AC motor or power converting means.

Now the present invention will be described in detail hereinafter with reference to the accompanied drawings which illustrate preferred embodiments of the present invention.
- Fig. 1: is a circuit block diagram of a control apparatus for an AC motor;
- Fig. 2: is a circuit block diagram showing a first modification of the apparatus of Fig. 1;
- Fig. 3: is a circuit block diagram showing a second modification of the apparatus of Fig. 1;
- Fig. 4: is a graph showing the first variation example of an output from the current pattern generator 21 of Fig. 3;
- Fig. 5: is a graph showing the second variation example of an output from the current pattern generator 21 of Fig. 3;
- Fig. 6: is a graph showing the third variation example of an output from the current pattern generator 21 of Fig. 3;
- Fig. 7: is a circuit diagram showing the connections between a three-phase electric power converter 7 which converts a DC current to a three-phase AC current and a three-phase AC motor 6 driven by the three-phase electric power supplied from the power converter 7;
- Fig. 8: is a circuit block diagram showing the first embodiment of the present invention;
- Fig. 9: is a circuit block diagram showing the second embodiment of the present invention; and
- Fig. 10: is a circuit block diagram showing the third embodiment of the present invention.

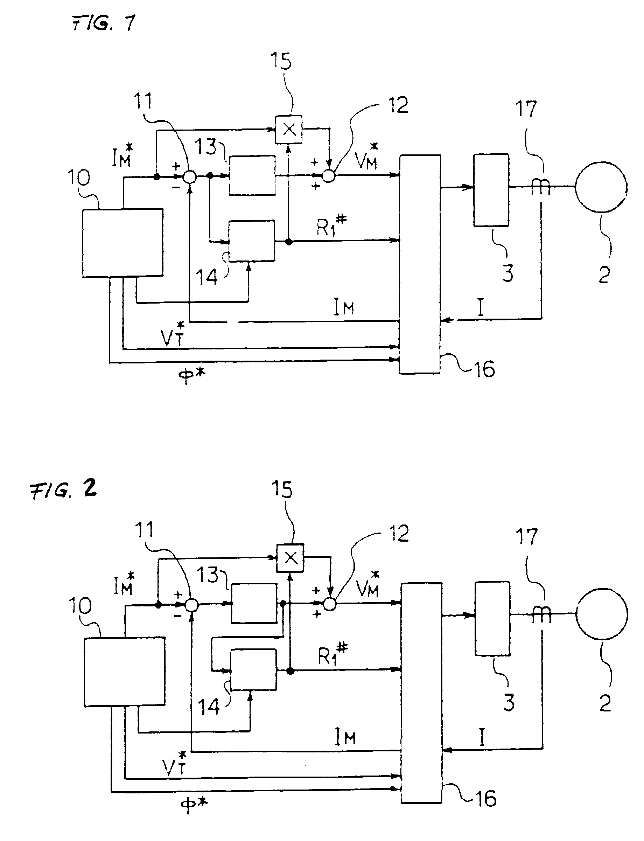

Figure 1 is a circuit block diagram showing a control apparatus for an AC motor. In the figure, a current detector 17 detects a current flowing from a power converter 3 to an AC motor 2. A voltage current control circuit 16 resolves the detected current value I into a detected magnetizing current value I_{M} and a detected torque current value I_{T} orthogonal to each other. Since the torque current value I_{T} and a reference torque voltage value V_{T}* do not relate to the present invention, their explanations are omitted.

An adder 11 calculates the deviation of a reference magnetizing current value I_{M}* output from a reference value generator circuit 10 and the detected magnetizing current value I_{M}, and outputs the calculated deviation to an amplifier circuit 13 and a regulator circuit 14 comprised of an integral or a proportional plus integral circuit. Since the estimated primary resistance value R₁^{#} coincides with the actual primary resistance value R₁ when the deviation of the reference magnetizing current value I_{M}* from the detected magnetizing current value I_{M} is zero, I_{M}*=I_{M}, as equation 5 expresses, the regulator circuit 14 outputs the estimated primary resistance value R₁^{#}, which becomes identical to the actual primary resistance value R₁. A multiplier 15 multiplies the thus obtained estimated primary resistance value R₁^{#} and the reference magnetizing current value I_{M}* to obtain the voltage drop across the primary resistance. A reference magnetizing voltage value V_{M}* is obtained, as equation 1 expresses, by adding in an adder 12 the voltage drop and the output from the amplifier circuit 13. The reference torque voltage value V_{T}* is also used for controlling the power converter 3 through the voltage current control circuit 16. In Fig. 1, φ* designates a reference phase value.

Figure 2 is a circuit block diagram showing a first modification of the apparatus of Fig. 1. In this modification, the circuit is configured similarly to that of Fig. 1 except that the output signal from the amplifier circuit 13 is fed to the regulator circuit 14 comprised of an integral circuit or a proportional plus integral circuit. As Fig. 2 shows, the same effect is obtained irrespective of whether the input signal to the regulator circuit 14 is the calculation result of the adder 11 or the amplified calculation result of the adder 11 amplified through the amplifier circuit 13.

The control methods explained above obtain the estimated primary resistance value R₁^{#} based on the difference between the detected magnetizing current value I_{M} and the reference magnetizing current value I_{M}*. Since, according to the prior art, the primary resistance value is obtained directly from the current and voltage drop, precision of the detectors have affected the measured values and improvement of the detector precision has not contributed to the accuracy improvement of the measured values in the case of large capacity AC motors. The present control method facilitates estimating the primary resistance value R₁^{#} at any time without being affected by the detector precision even when the resistance value varies with temperature rise. The present control method also facilitates compensating wiring resistance between the power converting means and the AC motor or the voltage drop across the switching elements. The present control method is effective for safely estimating the primary resistance because the present control method simultaneously conducts current control.

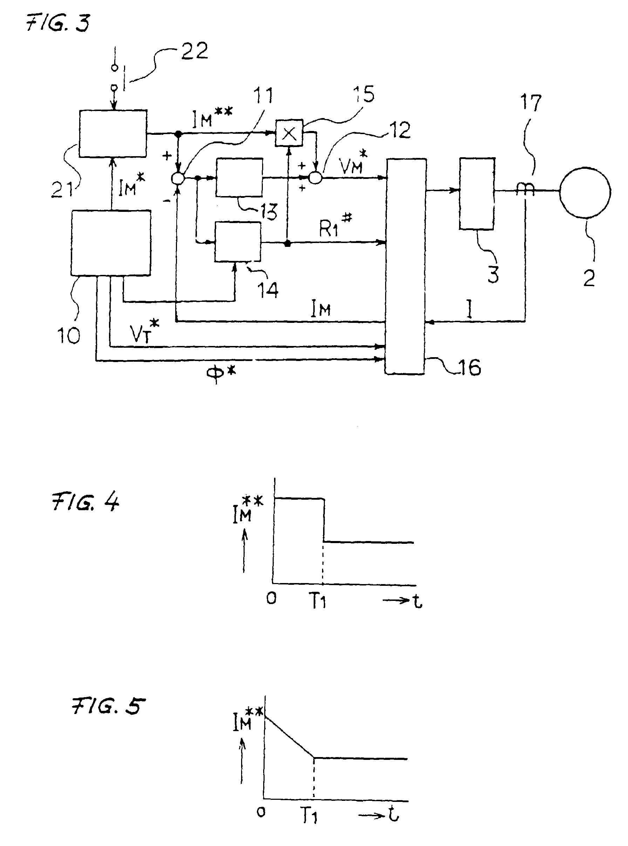

Figure 3 is a circuit block diagram showing a second modification of the apparatus of Fig. 1. In the apparatus of Fig. 3, names, functions and applications of the AC motor 2, power converter 3, reference value generator circuit 10, adders 11 and 12, amplifier circuit 13, regulator circuit 14, multiplier 15, voltage current control circuit 15 and current detector 17 are all the same with those in the apparatus of Fig. 1, and their explanations are omitted.

The apparatus of Fig. 3 is different from that of Fig. 1 in that the apparatus of Fig. 3 converts the reference magnetizing current value I_{M}* output from the reference value generator circuit 10 through a current pattern generator 21 to a varying reference magnetizing current value I_{M}**, and that an operation command switch 22 is incorporated. Though the calculation result of the adder 11 is input to the regulator circuit 14 in Fig. 3 similarly as in the apparatus of Fig.1, the amplified result of the amplifier 13, that amplifies the calculation result of the adder 11, may be input to the regulator circuit 14 in the same way as in the apparatus of Fig.2.

As described earlier, it takes long time for the estimated resistance value of a large capacity AC motor estimated by dividing the output voltage by a current to reach the true primary resistance value, because the decay time of the induced electromotive force is prolonged because of the large secondary time constant of the large capacity AC motor. To solve this problem, the apparatus of Fig. 3 inputs a start command which indicates start point of the AC motor 2 to the current pattern generator 21 through the operation command switch 22. The current pattern generator 21 outputs, in response to the input start command, the varying reference magnetizing current value I_{M}** decreasing according to the current pattern from the initial large value to a predetermined value after a predetermined period of time has elapsed and shortens the time for the estimated resistance value to reach the true primary resistance value.

Figure 4 is a graph showing a first example of an output variation of the current pattern generator 21 of Fig. 3. In Fig. 4, the abscissa represents time and the ordinate the varying reference magnetizing current value I_{M}**, I_{M}** takes a large value at the zero point of time when the AC motor 2 starts and decreases to a predetermined value at T1 when a predetermined time has elapsed.

Figure 5 is a graph showing a second example of an output variation of the current pattern generator 21 of Fig. 3. In Fig. 5, the abscissa represents time and the ordinate the varying reference magnetizing current value I_{M}**. I_{M}** takes a large value at the zero point of time when the AC motor 2 starts, decreases linearly with elapse of time and reaches the predetermined value at T1 when a predetermined time has elapsed.

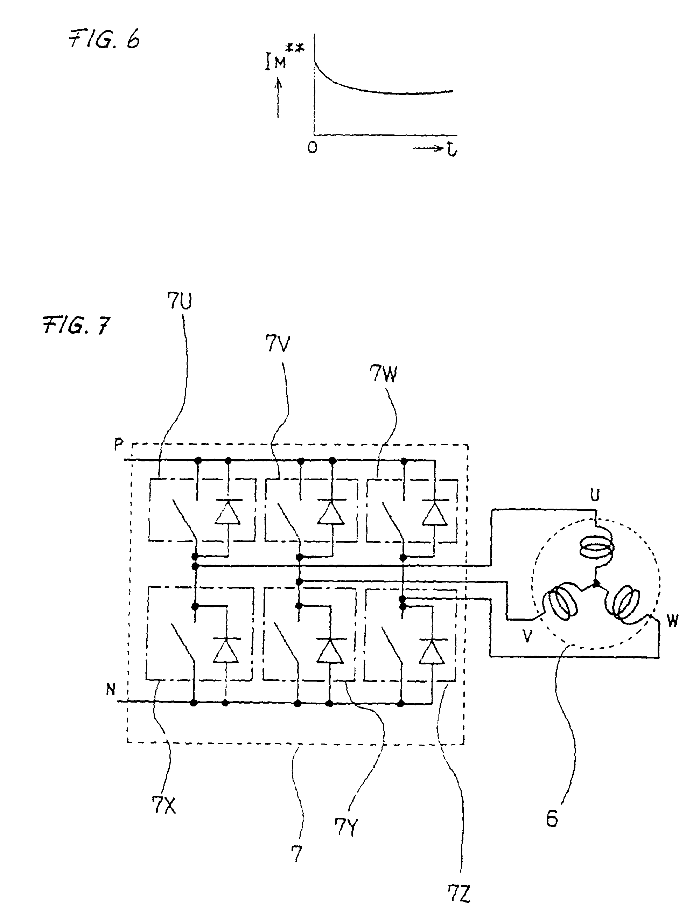

Figure 6 is a graph showing a third example of an output variation of the current pattern generator 21 of Fig. 3. In Fig. 6, the abscissa represents time and the ordinate the varying reference magnetizing current value I_{M}**. I_{M}** decreases exponentially with elapse of time from the initial large value at the time when the AC motor 2 starts and finally reaches the predetermined value.

As explained, this apparatus of Fig. 3 varies the reference magnetizing current value by means of the current pattern generator to reduce the effect of induced electromotive force of the motor which affects estimation of the primary resistance value at the start of the motor, facilitates estimating the primary resistance value in a short time even if the motor is of large capacity, the secondary time constant of which is large.

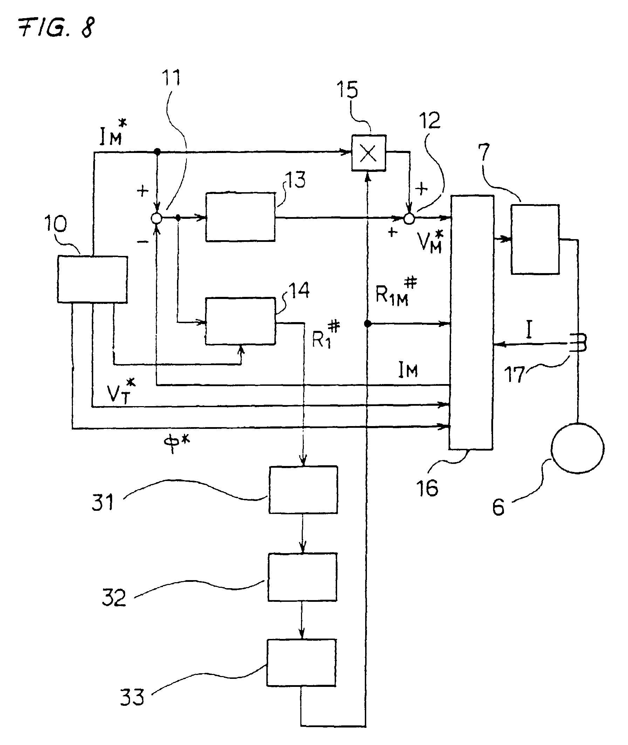

Figure 7 is a circuit diagram showing connections between a three-phase electric power converter 7 which converts a DC current to a three-phase AC current and a three-phase AC motor 6 driven by the three-phase electric power supplied from the power converter 7. As Fig. 7 shows, the three-phase electric power converter 7 is constructed by bridge-connecting six switching elements, 7U, 7V, 7W on the positive side and 7X, 7Y, 7Z on the negative side. A current flows through two phases of the three-phase AC motor 6 when either one of the switching elements 7U, 7V or 7W on the positive side and either one of the switching elements 7X, 7Y or 7Z on the negative side are turned on, while avoiding arm short circuit, that is, simultaneous turning-on of the switching elements which belong to the same phase.

Figure 8 is a circuit block diagram showing a first embodiment according to the present invention. In the first embodiment of Fig. 8, names, functions and applications of the reference value generator circuit 10, adders 11 and 12, amplifier circuit 13, regulator circuit 14, multiplier 15, voltage current control circuit 15 and current detector 17 are all the same with those in the apparatus of Fig. 1, and their explanations are omitted. In the first embodiment, the three-phase electric power converter 7 supplies three-phase AC electric power to the three-phase AC motor 6.

Phases through which a current flows and switching elements of the power converter 7 to be turned on change with the variation of phase angle of voltage applied to the three-phase AC motor 6. Because of this, the actual primary resistance value varies with the variation of the phase angle, which may cause control accuracy deterioration. To solve this problem, the first embodiment outputs a reference phase value φ* which assigns a respective one of six sets or pairs of the switching elements of the power converter 7 to be simultaneously turned-on according to the assignment listed in Table 1.

**Table 1**

| Assignment of the switching elements to be simultaneously turned-on | | |
|---|---|---|
| | Switching elements to be turned on | Motor windings through which current flows |
| 1 | 7U, 7Y | U-phase → V-phase |
| 2 | 7U, 7Z | U-phase → W-phase |
| 3 | 7V, 7X | V-phase → U-phase |
| 4 | 7V, 7Z | V-phase → W-phase |
| 5 | 7W, 7X | W-phase → U-phase |
| 6 | 7W, 7Y | W-phase → V-phase |

The estimated primary resistance values R₁^{#}s for the six pairs listed in Table 1, output from the regulator circuit 14, are stored in a phase resistance value storage circuit 31 with reference to each phase angle. Alternatively, converted estimated primary resistance values for each phase are stored in the phase resistance value storage circuit 31. A mean value calculation circuit 32 calculates a mean value of the stored data and the calculated mean primary resistance value R_{1M}^{#} is stored in a mean resistance value storage circuit 33. The stored mean primary resistance value R_{1M}^{#} is used for calculating the voltage drop across the primary resistance of the three-phase AC motor 6.

Though, in the first embodiment, the calculation result of the adder 11 is input to the regulator circuit 14 in Fig. 8 similarly as in the apparatus of Fig. 1, the amplified result of the amplifier 13, that amplifies the calculation result of the adder 11, may be input to the regulator circuit 14 in the same way as in the apparatus of Fig. 2.

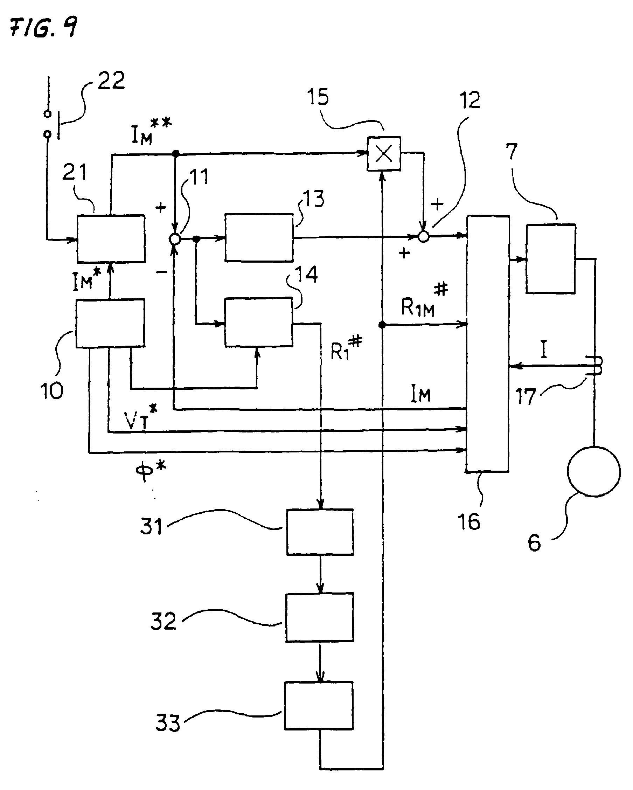

Figure 9 is a circuit block diagram showing a second embodiment. The second embodiment of Fig. 9 is constructed by providing the first embodiment of Fig. 8 with the current pattern generator circuit 21 and the operation command switch 22. The functions of the current pattern generator circuit 21 and the operation command switch 22 are the same with those of the apparatus of Fig. 3, and the functions of the constituents are the same with those of the first embodiment of Fig. 8. So, further explanations of the second embodiment are omitted. Though the calculation result of the adder 11 is input to the regulator circuit 14 in Fig. 9 similarly as in the apparatus of Fig. 1, the amplified result of the amplifier 13, that amplifies the calculation result of the adder 11, may be input to the regulator circuit 14 in the same way as in the apparatus of Fig. 2.

There are six pairs of the switching elements, each pair comprising one switching element on the positive side and another on the negative, side to be turned on at the same time to make a current flow through two phases of the three-phase AC motor. According to the first and second embodiments of the invention the primary resistance values for the six pairs are estimated and the voltage drop is obtained by using the mean value of the estimated primary resistance values. These control methods are effective for reducing the effect of variations of the resistance values among the switching elements or the motor windings. Estimating the primary resistance value in a short time is facilitated by varying the reference magnetizing current value by means of the current pattern generator.

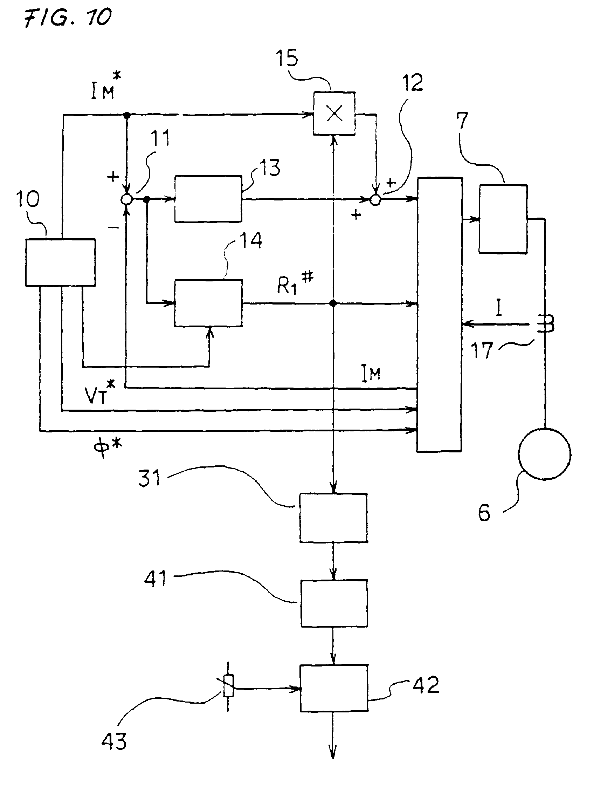

Figure 10 is a circuit block diagram showing a third embodiment. In the third embodiment of Fig. 10, names, functions and applications of the three-phase AC motor 6, three-phase electric power converter 7, reference value generator circuit 10, adders 11 and 12, amplifier circuit 13, regulator circuit 14, multiplier 15, voltage current control circuit 15 and current detector 17 are all the same with those in the first embodiment of Fig. 8, and their explanations are omitted. Though, in the third embodiment, the calculation result of the adder 11 is input to the regulator circuit 14 in Fig. 10 similarly as in the apparatus of Fig. 1, the amplified result of the amplifier 13, that amplifies the calculation result of the adder 11, may be input to the regulator circuit 14 in the same way as in the apparatus of Fig. 2.

The three-phase AC motor 6 is driven in an open phase state or an unbalance between phase currents occurs when any of the switching elements of the power converter 7 malfunctions, when the wiring between the power converter 7 and the motor 6 is broken or when the wiring is mis-connected. To solve these problems, a following test is conducted prior to driving the motor 6 to check whether the above malfunctions exist or not.

The reference value generator circuit 10 outputs the reference phase value φ* which assigns a respective one of six sets or pairs of the switching elements of the power converter 7 to be simultaneously turned on according to the assignment listed in Table 1. The estimated primary resistance values R₁*s for the six pairs listed in Table 1, output from the regulator circuit 14, are stored in the phase resistance value storage circuit 31 with reference to each phase angle. Alternatively, converted estimated primary resistance values R₁*s for each phase are stored in the phase resistance value storage circuit 31. A resistance value comparing circuit 41 compares the stored phase resistance values with each other and outputs deviations as the result of the comparison to a comparator 42. The comparator 42 outputs an alarm signal when an input deviation exceeds a predetermined value set from a deviation setter 43.

As will be understood by those skilled in the art, the malfunction detection aspect of the third embodiment may advantageously be combined with any of the preceding embodiments when applied to control a multi-phase AC motor.

As explained above, there are six pairs of the switching elements, each pair comprising one switching element on the positive side and another on the negative side, to be turned on at the same time to make a current flow through two phases of the three-phase AC motor. The malfunction detection method according to the third embodiment of the invention estimates the primary resistance values for the six pairs and compares the estimated primary resistance values with each other to detect an intolerable unbalance between the resistance values of the phases. This malfunction detection method is effective for easily detecting the malfunctions in advance such as malfunctions of the switching elements, breaking of wire, open phase operation of the motor caused by breaking or mis-connection of the motor windings, and unbalance among the phase currents. Malfunctions other than the malfunctions of the switching elements, which need not consider allowable pairs of the switching elements, can be detected from at least three pairs of the switching elements.

## Claims

1. A method of controlling a three-phase AC motor via a power converter (3) comprising a three-phase bridge circuit of switching elements , comprising the steps of:
(a) resolving a detected value of a current flowing through said AC motor into a magnetizing current component (I_{M}) parallel to a magnetic flux and a torque current component perpendicular to said magnetic flux,
(b) obtaining the deviation of said magnetizing current component (I_{M}) from a reference magnetizing current value (I_{M}*),
(c) executing a control operation for equalizing said magnetizing current component (I_{M}) to said reference magnetizing current value (I_{M}*),
(d) obtaining an estimated resistance value (R₁^{#}) from an integral operation or from a proportional plus integral operation on said deviation of said magnetizing current component (I_{M}) from said reference magnetizing current value (I_{M}*);
(e) obtaining an estimated voltage drop across said primary resistance by multiplying said estimated resistance value (R₁^{#}) and said reference magnetizing current value (I_{M}*);
(f) obtaining a reference magnetizing voltage value (V_{M}*) by adding a value corresponding to said deviation to said estimated voltage drop , and
(g) driving said AC motor at a desired speed with AC electric power output from a power converter (3) controlled with said reference magnetizing voltage value and a reference torque voltage value,
said control method being **characterized in that**:
step (d) comprises obtaining estimated resistance values for each of six sets of currents of two phases of said three-phase AC motor supplied by actions of one switching element on a positive side and another switching element on a negative side of said power converter (3), and calculating a mean resistance value of said estimated six resistance values; and
step (e) comprises obtaining said estimated voltage drop across said primary resistance by multiplying said mean resistance value and said reference magnetizing current value (I_{M}*).

2. The method of claim 1, wherein said reference magnetizing current value (I_{M}*) is varied from an initial large value to a predetermined smaller value within a predetermined period of time beginning at the start of said AC motor.

3. The method of claim 1 or 2, further comprising the steps:
(i) comparing at least three of said estimated resistance values with each other; and
(j) detecting a malfunction from a difference between said estimated resistance values which exceeds a predetermined value.

4. A method of controlling a three-phase AC motor, comprising the steps of:
(a) resolving a detected value of a current flowing through said AC motor into a magnetizing current component (I_{M}) parallel to a magnetic flux and a torque current component perpendicular to said magnetic flux,
(b) obtaining the deviation of said magnetizing current component (I_{M}) from a reference magnetizing current value (I_{M}*),
(c) executing a control operation for equalizing said magnetizing current component (I_{M}) to said reference magnetizing current value (I_{M}*),
(d) obtaining an estimated resistance value (R₁^{#}) from an integral operation or from a proportional plus integral operation on the deviation obtained in step (b),
(e) obtaining a reference magnetizing voltage value (V_{M}*) by adding a value corresponding to said deviation and the voltage drop across the primary resistance of said AC motor, and
(f) driving said AC motor at a desired speed with AC electric power output from a power converter (3) controlled with said reference magnetizing voltage value and a reference torque voltage value, said power converter (3) comprising a three-phase bridge circuit of switching elements,
said control method being **characterized by** comprising the further steps of:
(g) obtaining at least three estimated resistance values from integral operations or from proportional plus integral operations on the deviations of respective magnetizing current components from said reference magnetizing current value for each of at least three sets of currents of two phases of said three-phase AC motor supplied by actions of one switching element on a positive side and another switching element on a negative side of said power converter (3);
(h) comparing said at least three estimated resistance values with each other; and
(i) detecting a malfunction from a difference between said estimated resistance values which exceeds a predetermined value.

5. A control apparatus for an AC motor (2), comprising:
means (16) for resolving a detected value of a current flowing through said AC motor into a magnetizing current component (I_{M}) parallel to a magnetic flux and a torque current component perpendicular to said magnetic flux,
means (11) for obtaining the deviation of said magnetizing current component (I_{M}) from a reference magnetizing current value (I_{M}*),
means (13, 16) for executing a control operation for equalizing said magnetizing current component (I_{M}) to said reference magnetizing current value (I_{M}*),
means (14) for obtaining an estimated resistance value (R₁^{#}) from an integral operation or from a proportional plus integral operation on said deviation of said magnetizing current component (I_{M}) from said reference magnetizing current value (I_{M}*);
means (15) for obtaining an estimated voltage drop across said primary resistance by multiplying said estimated resistance value (R₁^{#}) and said reference magnetizing current value (I_{M}*);
means (12) for obtaining a reference magnetizing voltage value (V_{M}*) by adding a value corresponding to said deviation to said estimated voltage drop, and
means (10) for driving said AC motor (2) at a desired speed with AC electric power output from a power converter (3) controlled with said reference magnetizing voltage value (V_{M}*) and a reference torque voltage value (V_{T}*), said power converter (3) comprising a three-phase bridge circuit of switching elements,
said apparatus being **characterized in that**:
said means (14) for obtaining an estimated resistance value comprises means (31) for obtaining estimated resistance values for each of six sets of currents of two phases of said three-phase AC motor supplied by actions of one switching element on a positive side and another switching element on a negative side of said power converter (3) and means (32) for calculating a mean resistance value of said estimated six resistance values; and said means (15) for obtaining an estimated voltage drop comprises means for obtaining said estimated voltage drop across said primary resistance by multiplying said mean resistance value and said reference magnetizing current value.

6. The apparatus of claim 5, further comprising means (21, 22) for varying said reference magnetizing current value (I_{M}*) from an initial large value to a predetermined smaller value within a predetermined period of time beginning at the start of said AC motor (2).

7. The apparatus of claim 6, further comprising:
means (41) for comparing at least three of said estimated resistance values with each other; and
means (42, 43) for detecting a malfunction from a difference between said estimated resistance values which exceeds a predetermined value.

8. A control apparatus for a three-phase AC motor, comprising:
means (16) for resolving a detected value of a current flowing through said AC motor into a magnetizing current component (I_{M}) parallel to a magnetic flux and a torque current component perpendicular to said magnetic flux,
means (11) for obtaining the deviation of said magnetizing current component (I_{M}) from a reference magnetizing current value (I_{M}*),
means (14, 31) for obtaining an estimated resistance value from an integral operation or from a proportional plus integral operation on said deviation of said magnetizing current component from said reference magnetizing current value (I_{M}*),
means (13, 16) for executing a control operation for equalizing said magnetizing current component (I_{M}) to said reference magnetizing current value (I_{M}*),
means (12) for obtaining a reference magnetizing voltage value (V_{M}*) by adding a value corresponding to said deviation and the voltage drop across the primary resistance of said AC motor, and
means (10) for driving said AC motor (2) at a desired speed with AC electric power output from a power converter (3) controlled with said reference magnetizing voltage value (V_{M}*) and a reference torque voltage value (V_{T}*), said power converter (3) comprising a three-phase bridge circuit of switching elements,
said apparatus being **characterized by** comprising:
means (14, 31) for obtaining at least three estimated resistance values from integral operations or from proportional plus integral operations on the deviations of respective magnetizing current components from said reference magnetizing current value (I_{M}*) for each of at least three sets of currents of two phases of said three-phase AC motor supplied by actions of one switching element on a positive side and another switching element on a negative side of said power converter (3);
means (41) for comparing said at least three estimated resistance values with each other; and
means (42, 43) for detecting a malfunction from a difference between said estimated resistance values which exceeds a predetermined value.

## Patentansprüche

1. Verfahren der Steuerung eines 3-Phasen-Wechselstrommotors über einen Stromrichter (3), der eine 3-Phasen-Brückenschaltung aus Schalterelementen aufweist, umfassend die Schritte:
(a) Auflösen eines gemessenen Wertes eines durch den Wechselstrommotor fließenden Stroms in eine Magnetisierungsstromkomponente (I_{M}) parallel zu einem magnetischen Fluß und eine Momentenstromkomponente senkrecht zu dem magnetischen Fluß,
(b) Ermitteln der Abweichung der Magnetisierungsstromkomponente (I_{M}) von einem Referenz-Magnetisierungsstromwert (I_{M}*),
(c) Ausführen eines Steuerbetriebs zur Angleichung der Magnetisierungsstromkomponente (I_{M}) an den Referenz-Magnetisierungsstromwert (I_{M}*),
(d) Ermitteln eines geschätzten Widerstandswerts (R₁^{#}) aus einer Integral-Operation oder einer Proportional-Plus-lntegral-Operation an der Abweichung der Magnetisierungsstromkomponente (IM) von dem Referenz-Magnetisierungsstromwert (I_{M}*);
(e) Ermitteln eines geschätzten Spannungsabfalls über dem Primärwiderstand durch Multiplizieren des geschätzten Widerstandswerts (R₁^{#}) mit dem Referenz-Magnetisierungsstromwert (I_{M}*);
(f) Ermitteln eines Referenz-Magnetisierungsspannungswerts (V_{M}*) durch Addieren eines der Abweichung entsprechenden Werts zu dem geschätzten Spannungsabfall, und
(g) Betreiben des Wechselstrommotors mit einer gewünschten Drehzahl mittels elektrischer Wechselstromleistung, die von einem Stromrichter (3) ausgegeben wird, welcher mit dem Referenz-Magnetisierungsspannungswert und einem Referenz-Momentenspannungswert gesteuert wird, wobei das Steuerverfahren dadurch gekennzeichnet ist, daß:
Schritt (d) umfaßt: Ermitteln der geschätzten Widerstandswerte für jeden von sechs Sätzen von Strömen zweier Phasen des 3-Phasen-Wechselstrommotors, die durch Wirkungen eines Schalterelements an einer positiven Seite und eines anderen Schalterelements an einer negativen Seite des Stromrichters (7) geliefert werden, und Berechnen eines mittleren Widerstandswerts der geschätzten sechs Widerstandswerte; und
Schritt (e) umfaßt: Ermitteln des geschätzten Spannungsabfalls über dem Primärwiderstand durch Multiplizieren des mittleren Widerstandswerts und des Referenz-Magnetisierungsstromwerts (I_{M}*).

2. Verfahren nach Anspruch 1, bei dem der Referenz-Magnetisierungsstromwert (I_{M}*) innerhalb einer vorbestimmten Zeitspanne, die mit dem Start des Wechselstrommotors beginnt, von einem anfänglichen großen Wert zu einem vorbestimmten kleineren Wert verändert wird.

3. Verfahren nach Anspruch 1 oder 2, ferner umfassend die Schritte:
(i) Vergleichen wenigstens dreier der geschätzten Widerstandswerte miteinander; und
(j) Erfassen einer Fehlfunktion aus einer Differenz zwischen den geschätzten Widerstandswerten, die einen vorbestimmten Wert übersteigt.

4. Verfahren der Steuerung eines 3-Phasen-Wechselstrommotors, umfassend die Schritte:
(a) Auflösen eines gemessenen Werts eines den Wechselstrommotor durchfließenden Stroms in eine Magnetisierungsstromkomponente (I_{M}) parallel zu einem magnetischen Fluß und eine Momentenstromkomponente senkrecht zu dem magnetischen Fluß,
(b) Ermitteln der Abweichung der Magnetisierungsstromkomponente (I_{M}) von einem Referenz-Magnetisierungsstromwert (I_{M}*),
(c) Ausführen einer Steueroperation zur Angleichung der Magnetisierungsstromkomponente (I_{M}) an den Referenz-Magnetisierungsstromwert (I_{M}*),
(d) Ermitteln eines geschätzten Widerstandswerts (R₁^{#}) anhand einer Integral-Operation oder einer Proportional-Plus-lntegral-Operation an der im Schritt (b) erhaltenen Abweichung,
(e) Ermitteln eines Referenz-Magnetisierungsspannungswerts (V_{M}*) durch Addieren eines der Abweichung entsprechenden Werts zu dem Spannungsabfall über dem Primärwiderstand des Wechselstrommotors, und
(f) Betreiben des Wechselstrommotors mit einer gewünschten Drehzahl mittels von einem Stromrichter (3) ausgegebener elektrischer Wechselstromleistung, welcher mit dem Referenz-Magnetisierungsspannungswert und einem Referenz-Momentenspannungswert gesteuert wird, wobei der Stromrichter (3) eine 3-Phasen-Brückenschaltung aus Schalterelementen aufweist,
wobei das Steuerverfahren gekennzeichnet ist durch die weiteren Schritte:
(g) Bestimmen wenigstens dreier geschätzter Widerstandswerte anhand von Integral-Operationen oder Proportional-Plus-lntegral-Operationen an den Abweichungen der jeweiligen Magnetisierungsstromkomponenten von dem Referenz-Magnetisierungsstromwert für jeden von wenigstens drei Sätzen von Strömen zweier Phasen des 3-Phasen-Wechselstrommotors, die durch Wirkungen eines Schalterelements an einer positiven Seite und eines anderen Schalterelements an einer negativen Seite des Stromrichters (3) geliefert werden;
(h) Vergleichen der wenigstens drei geschätzten Widerstandswerte miteinander; und
(i) Erfassen einer Fehlfunktion aus einer Differenz zwischen den geschätzten Widerstandswerten, die einen vorbestimmten Wert übersteigt.

5. Steuervorrichtung für einen Wechselstrommotor (2), umfassend:
Mittel (16) zur Auflösung eines gemessenen Werts eines durch den Wechselstrommotor fließenden Stroms in eine Magnetisierungsstromkomponente (I_{M}) parallel zu einem magnetischen Fluß und eine Momentenstromkomponente senkrecht zu dem magnetischen Fluß,
Mittel (11) zum Erhalt der Abweichung der Magnetisierungsstromkomponente (I_{M}) von einem Referenz-Magnetisierungsstromwert (I_{M}*),
Mittel (13, 16) zur Ausführung einer Steueroperation zur Angleichung der Magnetisierungsstromkomponete (I_{M}) an den Referenz-Magnetisierungsstromwert (I_{M}*),
Mittel (14) zum Erhalt eines geschätzten Widerstandswerts (R₁^{#}) anhand einer Integral-Operation oder einer Proportional-Plus-lntegral-Operation an der Abweichung der Magnetisierungsstromkomponente (I_{M}) von dem Referenz-Magnetisierungsstromwert (I_{M}*);
Mittel (15) zum Erhalt eines geschätzten Spannungsabfalls über dem Primärwiderstand durch Multiplizieren des geschätzten Widerstandswerts (R₁^{#}) und des Referenz-Magnetisierungsstromwerts (I_{M}*),
Mittel (12) zum Erhalt eines Referenz-Magnetisierungsspannungswerts (V_{M}*) durch Addieren eines der Abweichung entsprechenden Werts zu dem geschätzten Spannungsabfall, und
Mittel (10) zum Betrieb des Wechselstrommotors (2) mit einer gewünschten Drehzahl mittels elektrischer Wechselstromleistung, die von einem Stromrichter (3) ausgegeben wird, welcher mit dem Referenz-Magnetisierungsspannungswert (V_{M}*) und einem Referenz-Momentenspannungswert (V_{T}*) gesteuert wird, wobei der Stromrichter (3) eine 3-Phasen-Brückenschaltung aus Schalterelementen aufweist,
wobei die Vorrichtung dadurch gekennzeichnet ist, daß:
die Mittel (14) zum Erhalt eines geschätzten Widerstandswerts Mittel (31) umfassen zum Erhalt geschätzter Widerstandswerte für jeden von sechs Sätzen von Strömen zweier Phasen des 3-Phasen-Wechselstrommotors, die durch Wirkungen eines Schalterelements an einer positiven Seite und eines anderen Schalterelements an einer negativen Seite des Stromrichters (3) geliefert werden, sowie Mittel (32) zum Berechnen eines mittleren Widerstandswerts der geschätzten sechs Widerstandswerte; und die Mittel (15) zum Erhalt eines geschätzten Spannungsabfalls Mittel umfassen zum Erhalt des geschätzten Spannungsabfalls über dem Primärwiderstand durch Multiplizieren des mittleren Widerstandswerts und des Referenz-Magnetisierungsstromwerts.

6. Vorrichtung nach Anspruch 5, ferner umfassend Mittel (21, 22) zum Variieren des Referenz-Magnetisierungsstromwerts (I_{M}*) von einem anfänglichen großen Wert zu einem vorbestimmten kleineren Wert innerhalb einer vorbestimmten Zeitspanne, die mit dem Start des Wechselstrommotors (2) beginnt.

7. Vorrichtung nach Anspruch 6, ferner umfassend:
Mittel (41) zum Vergleich wenigstens dreier der geschätzten Widerstandswerte miteinander, und
Mittel (42, 43) zur Erfassung einer Fehlfunktion aus einer Differenz zwischen den geschätzten Widerstandswerten, die einen vorbestimmten Wert übersteigt.

8. Steuervorrichtung einen 3-Phasen-Wechselstrommotor, umfassend:
Mittel (16) zur Auflösung eines gemessenen Werts eines den Wechselstrommotor durchfließenden Stroms in eine Magnetisierungsstromkomponente (I_{M}) parallel zu einem magnetischen Fluß und eine Momentenstromkomponente senkrecht zu dem magnetischen Fluß,
Mittel (11) zum Erhalt der Abweichung der Magnetisierungsstromkomponente (I_{M}) von einem Bezugs-Magnetisierungsstromwert (I_{M}*),
Mittel (14, 31) zum Erhalt eines geschätzten Widerstandswerts anhand einer Integral-Operation oder einer Proportional-Plus-lntegral-Operation an der Abweichung der Magnetisierungsstromkomponente von dem Referenz-Magnetisierungsstromwert (I_{M}*),
Mittel (13, 16) zur Ausführung einer Steueroperation zur Angleichung der Magnetisierungsstromkomponente (I_{M}) an den Referenz-Magnetisierungsstromwert (I_{M}*),
Mittel (12) zum Erhalt eines Referenz-Magnetisierungsspannungswerts (V_{M}*) durch Addieren eines der Abweichung entsprechenden Werts zu dem Spannungsabfall über dem Primärwiderstand des Wechselstrommotors, und
Mittel (10) zum Betrieb des Wechselstrommotors (2) mit einer gewünschten Drehzahl mit elektrischer Wechselstromleistung, die von einem Stromrichter (3) ausgegeben wird, der mit dem Referenz-Magnetisierungsspannungswert (V_{M}*) und einem Referenz-Momentenspannungswert (V_{T}*) gesteuert wird, wobei der Stromrichter (3) eine 3-Phasen-Brückenschaltung aus Schalterelementen aufweist,
wobei die Vorrichtung gekennzeichnet ist durch:
Mittel (14, 31) zum Erhalt wenigstens dreier geschätzter Widerstandswerte anhand von Integral-Operationen oder Proportional-Plus-lntegral-Operationen an den Abweichungen jeweiliger Magnetisierungsstromkomponenten von dem Referenz-Magnetisierungsstromwert (I_{M}*) für jeden von wenigstens drei Sätzen von Strömen zweier Phasen des 3-Phasen-Wechselstrommotors, die durch Wirkungen eines Schalterelements an einer positiven Seite und eines anderen Schalterelements an einer negativen Seite des Stromrichters (3) geliefert werden;
Mittel (41) zum Vergleich der wenigstens drei geschätzten Widerstandswerte miteinander; und
Mittel (42, 43) zur Erfassung einer Fehlfunktion aus einer Differenz zwischen den geschätzten Widerstandswerten, die einen vorbestimmten Wert übersteigt.

## Revendications

1. Procédé de commande d'un moteur alternatif triphasé par un convertisseur de courant (3) comprenant un montage en pont triphasé d'éléments de commutation, comprenant les étapes consistant à :
(a) décomposer une valeur détectée d'un courant traversant ledit moteur alternatif en une composante de courant magnétisant (I_{M}) parallèle à un flux magnétique et une composante de courant de couple perpendiculaire audit flux magnétique,
(b) déterminer l'écart de ladite composante de courant magnétisant (I_{M}) par rapport à une valeur de courant magnétisant de référence (I_{M}*),
(c) exécuter une opération de commande pour rendre ladite composante de courant magnétisant (I_{M}) égale à ladite valeur de courant magnétisant de référence (I_{M}*),
(d) déterminer une valeur de résistance estimée (R₁^{#}) par une opération intégrale ou une opération proportionnelle et intégrale sur ledit écart de ladite composante de courant magnétisant (I_{M}) par rapport à ladite valeur de courant magnétisant de référence (I_{M}*);
(e) déterminer une chute de tension estimée à travers ladite résistance du primaire en multipliant ladite valeur de résistance estimée (R₁^{#}) et ladite valeur de courant magnétisant de référence (I_{M}*);
(f) déterminer une valeur tension magnétisante de référence (V_{M}*) en ajoutant une valeur correspondant audit écart à ladite chute de tension estimée, et
(g) entraîner ledit moteur alternatif à une vitesse souhaitée à l'aide d'une alimentation électrique alternative fournie par un convertisseur de courant (3) commandé avec ladite valeur de tension magnétisante de référence et une valeur de tension de couple de référence,
ledit procédé de commande étant caractérisé en ce que :
l'étape (d) comprend la détermination de valeurs de résistance estimées pour chacun de six ensembles de courants formés de deux phases dudit moteur alternatif triphasé fournis par des actions d'un élément de commutation situé d'un côté positif et d'un autre élément de commutation situé d'un côté négatif dudit convertisseur de courant (3), et le calcul d'une valeur de résistance moyenne desdites six valeurs de résistance estimées; et
l'étape (e) comprend la détermination de ladite chute de tension estimée à travers ladite résistance du primaire en multipliant ladite valeur de résistance moyenne et ladite valeur de courant magnétisant de référence (I_{M}*).

2. Procédé selon la revendication 1, dans lequel on fait varier ladite valeur de courant magnétisant de référence (I_{M}*) d'une valeur initiale élevée à une valeur prédéterminée plus petite pendant une durée prédéterminée commençant au démarrage dudit moteur alternatif.

3. Procédé selon la revendication 1 ou 2, comprenant de plus les étapes consistant à :
(i) comparer l'une avec l'autre au moins trois desdites valeurs de résistance estimées; et
(j) détecter un dysfonctionnement par une différence entre lesdites valeurs de résistance estimées qui dépasse une valeur prédéterminée.

4. Procédé de commande d'un moteur alternatif triphasé, comprenant les étapes consistant à :
(a) décomposer une valeur détectée d'un courant traversant ledit moteur alternatif en une composante de courant magnétisant (I_{M}) parallèle à un flux magnétique et une composante de courant de couple perpendiculaire audit flux magnétique,
(b) déterminer l'écart de ladite composante de courant magnétisant (I_{M}) par rapport à une valeur de courant magnétisant de référence (I_{M}*),
(c) exécuter une opération de commande pour rendre ladite composante de courant magnétisant (I_{M}) égale à ladite valeur de courant magnétisant de référence (I_{M}*),
(d) déterminer une valeur de résistance estimée (R₁^{#}) par une opération intégrale ou une opération proportionnelle et intégrale sur l'écart déterminé à l'étape (b),
(e) déterminer une valeur tension magnétisante de référence (V_{M}*) en ajoutant une valeur correspondant audit écart et la chute de tension à travers la résistance du primaire dudit moteur alternatif, et
(f) entraîner ledit moteur alternatif à une vitesse souhaitée à l'aide d'une alimentation électrique alternative fournie par un convertisseur de courant (3) commandé avec ladite valeur de tension magnétisante de référence et une valeur de tension de couple de référence, ledit convertisseur de courant (3) comprenant un montage en pont triphasé d'éléments de commutation,
ledit procédé de commande étant caractérisé en ce qu'il comprend les étapes supplémentaires consistant à :
(g) déterminer au moins trois valeurs de résistance estimées par des opérations intégrales ou des opérations proportionnelles et intégrales sur les écarts des composantes de courant magnétisant respectives par rapport à ladite valeur de courant magnétisant de référence pour chacun d'au moins trois ensembles de courants formés de deux phases dudit moteur alternatif triphasé fournis par des actions d'un élément de commutation situé d'un côté positif et d'un autre élément de commutation situé d'un côté négatif dudit convertisseur de courant (3);
(h) comparer l'une avec l'autre lesdites au moins trois valeurs de résistance estimées; et
(i) détecter un dysfonctionnement par une différence entre lesdites valeurs de résistance estimées qui dépasse une valeur prédéterminée.

5. Dispositif de commande d'un moteur alternatif (2), comprenant :
des moyens (16) pour décomposer une valeur détectée d'un courant traversant ledit moteur alternatif en une composante de courant magnétisant (I_{M}) parallèle à un flux magnétique et une composante de courant de couple perpendiculaire audit flux magnétique
des moyens (11) pour déterminer l'écart de ladite composante de courant magnétisant (I_{M}) par rapport à une valeur de courant magnétisant de référence (I_{M}*),
des moyens (13, 16) pour exécuter une opération de commande pour rendre ladite composante de courant magnétisant (I_{M}) égale à ladite valeur de courant magnétisant de référence (I_{M}*),
des moyens (14) pour déterminer une valeur de résistance estimée (R₁^{#}) par une opération intégrale ou une opération proportionnelle et intégrale sur ledit écart de ladite composante de courant magnétisant (I_{M}) par rapport à ladite valeur de courant magnétisant de référence (I_{M}*);
des moyens (15) pour déterminer une chute de tension estimée à travers ladite résistance du primaire en multipliant ladite valeur de résistance estimée (R1^{#}) et ladite valeur de courant magnétisant de référence (I_{M}*);
des moyens (12) pour déterminer une valeur de tension magnétisante de référence (V_{M}*) en ajoutant une valeur correspondant audit écart à ladite chute de tension estimée, et
des moyens (10) pour entraîner ledit moteur alternatif (2) à une vitesse souhaitée à l'aide d'une alimentation électrique alternative fournie par un convertisseur de courant (3) commandé avec ladite valeur de tension magnétisante de référence (V_{M}*) et une valeur de tension de couple de référence (V_{T}*), ledit convertisseur de courant (3) comprenant un montage en pont triphasé d'éléments de commutation,
ledit dispositif étant caractérisé en ce que :
lesdits moyens (14) pour déterminer une valeur de résistance estimée comprennent des moyens (31) pour déterminer des valeurs de résistance estimées pour chacun de six ensembles de courants formés de deux phases dudit moteur alternatif triphasé fournis par des actions d'un élément de commutation situé d'un côté positif et d'un autre élément de commutation situé d'un côté négatif dudit convertisseur de courant (3) et des moyens (32) pour calculer une valeur de résistance moyenne desdites six valeurs de résistance estimées; et lesdits moyens (15) pour déterminer une chute de tension estimée comprennent des moyens pour déterminer ladite chute de tension estimée à travers ladite résistance du primaire en multipliant ladite valeur de résistance moyenne et ladite valeur de courant magnétisant de référence.

6. Dispositif selon la revendication 5, comprenant de plus des moyens (21, 22) pour faire varier ladite valeur de courant magnétisant de référence (I_{M}*) d'une valeur initiale élevée à une valeur prédéterminée plus petite pendant une durée prédéterminée commençant au démarrage dudit moteur alternatif (2).

7. Dispositif selon la revendication 6, comprenant de plus :
des moyens (41) pour comparer l'une avec l'autre au moins trois desdites valeurs de résistance estimées; et
des moyens (42, 43) pour détecter un dysfonctionnement par une différence entre lesdites valeurs de résistance estimées qui dépasse une valeur prédéterminée.

8. Dispositif de commande d'un moteur alternatif triphasé, comprenant :
des moyens (16) pour décomposer une valeur détectée d'un courant traversant ledit moteur alternatif en une composante de courant magnétisant (I_{M}) parallèle à un flux magnétique et une composante de courant de couple perpendiculaire audit flux magnétique,
des moyens (11) pour déterminer l'écart de ladite composante de courant magnétisant (I_{M}) par rapport à une valeur de courant magnétisant de référence (I_{M}*),
des moyens (14, 31) pour déterminer une valeur de résistance estimée par une opération intégrale ou une opération proportionnelle et intégrale sur ledit écart de ladite composante de courant magnétisant à partir de ladite valeur de courant magnétisant de référence (I_{M}*),
des moyens (13, 16) pour exécuter une opération de commande pour rendre ladite composante de courant magnétisant (I_{M}) égale à ladite valeur de courant magnétisant de référence (I_{M}*),
des moyens (12) pour déterminer une valeur de tension magnétisante de référence (V_{M}*) en ajoutant une valeur correspondant audit écart et la chute de tension à travers la résistance du primaire dudit moteur alternatif, et
des moyens (10) pour entraîner ledit moteur alternatif (2) à une vitesse souhaitée à l'aide d'une alimentation électrique alternative fournie par un convertisseur de courant (3) commandé avec ladite valeur de tension magnétisante de référence (V_{M}*) et une valeur de tension de couple de référence (V_{T}*), ledit convertisseur de courant (3) comprenant un montage en pont triphasé d'éléments de commutation,
ledit dispositif étant caractérisé en ce qu'il comprend :
des moyens (14, 31) pour déterminer au moins trois valeurs de résistance estimées par des opérations intégrales ou des opérations proportionnelles et intégrales sur les écarts des composantes de courant magnétisant respectives par rapport à ladite valeur de courant magnétisant de référence (I_{M}*) pour chacun d'au moins trois ensembles de courants formés de deux phases dudit moteur alternatif triphasé fournis par des actions d'un élément de commutation situé d'un côté positif et d'un autre élément de commutation situé d'un côté négatif dudit convertisseur de courant (3);
des moyens (41) pour comparer l'une avec l'autre lesdites au moins trois valeurs de résistance estimées; et
des moyens (42, 43) pour détecter un dysfonctionnement par une différence entre lesdites valeurs de résistance estimées qui dépasse une valeur prédéterminée.
